# EUROPEAN PATENT APPLICATION

(11) **EP 2 372 911 A1**
(43) Date of publication of application: **05.10.2011**
(21) Application number: 10250719.1
(22) Date of filing: 01.04.2010
(51) Int. Cl.: H03H 11/24

(54) **Constant impedance variable attenuator**

(71) Applicant: Thales Holdings UK Plc, Addlestone, Surrey KT15 2NX (GB)
(72) Inventor: Ward, Chris, Worton Grange Reading RG2 0SB (GB)
(74) Representative: Maury, Richard Philip

(57) **Abstract**

An RF attenuator circuit comprising: at least a first voltage-variable resistive device connected between input and output nodes of the circuit to convey an RF signal along a signal path between the input and output nodes; at least a second voltage-variable resistive device connected between the signal path and ground; a differential amplifier having one input connected to means for supplying a reference voltage, another input coupled to the input node, and an output connected to the control voltage input of one of the voltage-variable resistive devices; an attenuator control voltage node connected to the control voltage input of the other voltage-variable resistive device; a predetermined impedance matching the expected output load impedance of the attenuator and connected between the output node and ground; and a constant current source connected to supply a constant current to the input node; the reference voltage being the constant current multiplied by the value of the matching impedance; whereby the differential amplifier provides a closed servo loop between the input node and at least one of the voltage-variable resistive devices to cause that device to slew to a resistance that presents the predetermined impedance at the input node, to preserve the voltage standing wave ratio of a signal conveyed through the attenuator circuit when the gain is changed by the attenuator control voltage applied to the attenuator control voltage node.

## Description

This invention relates to a variable RF attenuator which presents a constant impedance to a load. The invention is particularly useful in RF applications that require continuous analogue control of the attenuation of a signal whilst maintaining an unchanging VSWR, Voltage Standing Wave Ratio.

Conventional RF attenuators have had T or Pi structures typically made from PIN diodes or "cold" FETs, requiring two separate drive voltages, since the resistance values that are needed differ significantly. For example, in a T attenuator, the two series resistances might vary between 0Ω and 50Ω whilst the shunt resistance needs to change between an open circuit (infinity) and zero resistance. By way of example, a T attenuator is disclosed in US patent 5,453,721. Whatever the control elements are, it is difficult to design a circuit that produces both drive signals accurately, and the necessary compromises result in a degradation in VSWR, usually at the extremes of the attenuation range.

The purpose of the present invention is to overcome or mitigate the deficiencies of conventional attenuators.

The present invention provides an RF attenuator circuit comprising: at least a first voltage-variable resistive device connected between input and output nodes of the circuit to convey an RF signal along a signal path between the input and output nodes; at least a second voltage-variable resistive device connected between the signal path and ground; a differential amplifier having one input connected to means for supplying a reference voltage, another input coupled to the input node, and an output connected to the control voltage input of one of the voltage-variable resistive devices; an attenuator control voltage node connected to the control voltage input of the other voltage-variable resistive device; a predetermined impedance matching the expected output load impedance of the attenuator and connected between the output node and ground; and a constant current source connected to supply a constant current to the input node; the reference voltage being the constant current multiplied by the value of the matching impedance; whereby the differential amplifier provides a closed servo loop between the input node and at least one of the voltage-variable resistive devices to cause that device to slew to a resistance that presents the predetermined impedance at the input node, to preserve the voltage standing wave ratio of a signal conveyed through the attenuator circuit when the gain is changed by the attenuator control voltage applied to the attenuator control voltage node.

With a single control voltage (drive) input to one of the resistive devices, the second drive signal is generated by the differential amplifier so as to give an ideal impedance match at that attenuation setting. The circuit does not require well-characterised devices and it is capable of adapting to changes with temperature and aging and so on.

When the input impedance of the circuit being driven is not matched, but is a relatively constant resistance over the bandwidth of operation, that resistance may be set in the attenuator, and the circuit will then adopt values that maintain a match upstream for all attenuation values.

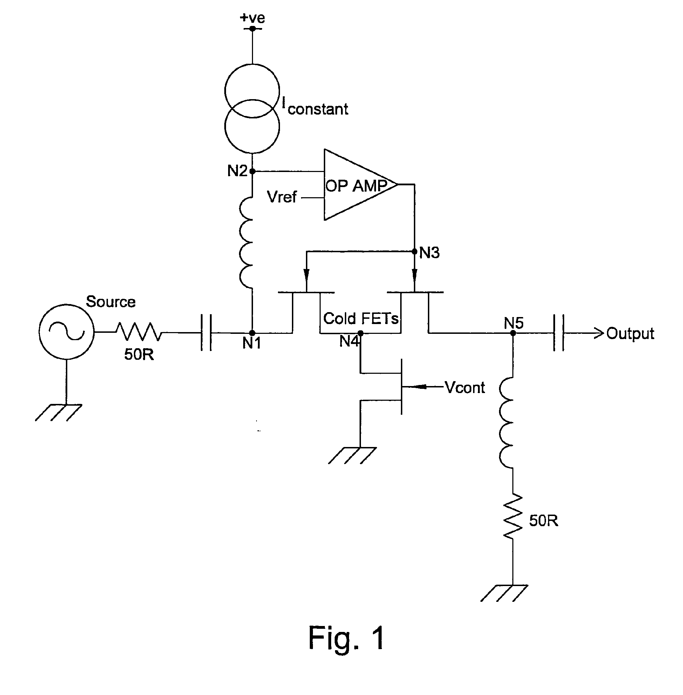

In order that the invention may be better understood, a preferred embodiment will now be described, by way of example, with reference to the accompanying drawing, Fig. 1, which is a circuit diagram of a preferred embodiment.

The RF variable attenuator of Fig. 1 consists of a T structure of three cold FETs: first and second transistors are connected in series at a common node N4, between an input node N1 and an output node N5. A third FET is connected as a shunt between the common node N4 and ground, and its gate is connected to an input port for receiving a gain control voltage V_{cont}. An RF signal source with a nominal impedance of 50Ω is AC-coupled through a capacitor to the input node N1. The output node N5 is connected through an inductance and a resistance of nominally 50Ω to ground, and the output node N5 is AC-coupled through a capacitor to a load. In the event that the output load impedance differs from 50Ω, then the value of the resistance that is connected to ground is changed to the resistive equivalent of the average return loss for the load.

The values of the two capacitances and of the two inductors of the circuit of Fig. 1 are selected appropriately for respectively coupling and blocking RF.

A current source I_{constant} is connected at a node N2 to a first input of an OP AMP, and this node N2 is also connected through an inductance to the input node N1. The other input of the OP AMP is connected to means for supplying a fixed reference voltage V_{ref} which is set at 50Ω multiplied by the value of the bias current i.e. the constant current. The output of the OP AMP is connected at a node N3 to the gates of the first and second FETs.

The operational amplifier OP AMP monitors the voltage across the attenuator input. The output voltage at node N3 is thus caused by the operational amplifier to slew to whatever voltage is necessary at the gates of the FETs to establish a matched condition for the FETs and to present 50Ω at the input node N1. This accommodates manufacturing tolerances in the voltage needed to get a particular source-drain resistance. The speed of response is determined by the bandwidth of the operational amplifier and by the coupling capacitor time constants. For VHF frequencies and higher frequencies of operation, a control bandwidth of several tens of MHz should be possible.

The impedance of 50Ω is given here by way of example, and clearly other values could be substituted, for example in the range of 10Ω to 100Ω.

It will be understood that both depletion mode and enhancement mode MOSFETs could be used in place of the cold FETs as they too work without a DC bias voltage between source and drain, i.e. in the same way as a voltage-controlled resistor. The operational amplifier could be replaced by any appropriately designed differential amplifier. The devices shown in the attenuator circuit of Fig. 1 are given by way of example only.

This circuit in effect provides a closed loop servo around a cold FET attenuator. In certain circumstances, it is desirable to provide a negative feedback servo loop, by exchanging the positions of the OP AMP output and the gain control voltage V_{cont}.

An alternative embodiment of the invention has a Pi attenuator configuration rather than a T configuration: one FET between the input and ground; a second FET between input and output, and a third FET between the output terminal and ground. The gates of the first and third FETs are connected.

## Claims

1. An RF attenuator circuit comprising: at least a first voltage-variable resistive device connected between input and output nodes of the circuit to convey an RF signal along a signal path between the input and output nodes; at least a second voltage-variable resistive device connected between the signal path and ground; a differential amplifier having one input connected to means for supplying a reference voltage, another input coupled to the input node, and an output connected to the control voltage input of one of the voltage-variable resistive devices; an attenuator control voltage node connected to the control voltage input of the other voltage-variable resistive device; a predetermined impedance matching the expected output load impedance of the attenuator and connected between the output node and ground; and a constant current source connected to supply a constant current to the input node; the reference voltage being the constant current multiplied by the value of the matching impedance; whereby the differential amplifier provides a closed servo loop between the input node and at least one of the voltage-variable resistive devices to cause that device to slew to a resistance that presents the predetermined impedance at the input node, to preserve the voltage standing wave ratio of a signal conveyed through the attenuator circuit when the gain is changed by the attenuator control voltage applied to the attenuator control voltage node.

2. A circuit according to claim 1, in which there is a third voltage-variable resistive device in series in the signal path, with its control voltage input connected to that of the first voltage-variable resistive device, the second voltage-variable resistive device being connected to a common node between the first and third voltage-variable resistive devices.

3. A circuit according to claim 1, in which there is a third voltage-variable resistive device connected to ground in parallel with the second voltage-variable resistive device, the second and third voltage-variable resistive devices being connected respectively to the input and output nodes, and having their control voltage inputs connected together.

4. A circuit according to any preceding claim, in which the differential amplifier is an operational amplifier.

5. A circuit according to any preceding claim, in which the voltage-variable resistive devices are cold FETs.

6. A circuit according to any preceding claim, in which the impedance is between 10Ω and 100Ω.

7. A circuit according to claim 6, in which the impedance is about 50Ω.

8. An RF signal generator comprising an RF source AC-coupled to the input node of an RF attenuator circuit according to any preceding claim, and a load AC-coupled to the output node.
